## Europäisches Patentamt
## European Patent Office
## Office européen des brevets

(11) Publication number: **0 029 858**
**B1**

(12) **EUROPEAN PATENT SPECIFICATION**

(45) Date of publication of patent specification: **21.11.85**

(51) Int. Cl.⁴: **H 01 L 23/02**

(21) Application number: **80901079.6**

(22) Date of filing: **14.06.80**

(86) International application number:
**PCT/JP80/00131**

(87) International publication number:
**WO 80/02891 24.12.80 Gazette 80/29**

(54) **SEMICONDUCTOR DEVICE.**

(30) Priority: **15.06.79 JP 75289/79**

(43) Date of publication of application:
**10.06.81 Bulletin 81/23**

(45) Publication of the grant of the patent:
**21.11.85 Bulletin 85/47**

(84) Designated Contracting States:
**DE FR GB NL**

(56) References cited:
**DE-A-2 543 968**
**FR-A-2 022 876**
**JP-A-55 068 659**

**17th ANNUAL PROCEEDINGS RELIABILITY PHYSICS 1979, April 24-26, 1979, SAN FRANCISCO (US), E.S. MEIERAN et al.: Measurement of alpha particle radioactivity in IC device packages", pages 13-22**
**IBM TECHNICAL DISCLOSURE BULLETIN, vol. 22, no. 12, May 1980, NEW YORK (US), H.C. BARON et al.: "Low cost alpha particle shielding process", pages 5284-5285**

(73) Proprietor: **FUJITSU LIMITED**
**1015, Kamikodanaka Nakahara-ku**
**Kawasaki-shi Kanagawa 211 (JP)**

(72) Inventor: **HONDA, Norio 21-4, Aza Miyashita**
**Ooaza Kamiarakuda Machikitamachi**
**Aizuwakamatsu-shi Fukushima 965 (JP)**

(74) Representative: **Allman, Peter John et al**
**Marks and Clerk Scottish Life House Bridge Street**
**Manchester M3 3DP (GB)**

Courier Press, Leamington Spa, England.

## Description

### Technical field

This invention relates to a semiconductor device having a structure such that a semiconductor element formed on one side of a semiconductor chip is shielded from radioactive rays emitted from the parts packaged in the rest of the semiconductor device.

### Background art

In general, semiconductor devices have a package structure such that a chip with a semiconductor element formed on one side thereof is fixed in a recess formed in a carrier made of an insulating material such as ceramics, and is further sealed with a cover or lid with a predetermined space therebetween. Where the semiconductor elements sealed in the package structure are composed of high density integrated circuits, such as a MOS device and charge transfer device, the semiconductor elements are liable to suffer from soft errors and deteriorate in their characteristics due to the influence of alpha rays and other radiation emitted by radioactive decay of traces of radioactive elements, such as uranium and thorium, present in the packaged parts. Most crucial is irradiation of the semiconductor element surface with alpha rays. This soft-error problem due to α-particles is discussed in an article "Measurement of alpha particle—", 17th Annual Proceedings Reliability Physics 1979, April 24—26, 1979. This document describes a device comprising a chip with a semiconductor element formed on one side thereof, said chip being fixed in a recess formed in an insulating carrier sealed with a cover. A shielding material may be applied directly to the chip.

It is, therefore, a primary object of the present invention to provide semiconductor devices wherein a semiconductor element formed on one side of a semiconductor chip is shielded from alpha rays and other radiation emitted from the packaged parts, and, thus, which devices neither cause soft errors nor deteriorate in their characteristics.

The present invention provides a semiconductor device comprising a chip with a semiconductor element formed on one side thereof, said chip being fixed in a recess formed in a carrier made of an insulating material and being sealed with a cover with a predetermined space therebetween; said device further comprising (a) a layer of a thermally resisting, insulating material exhibiting a particle flux of not larger than 0.1 particle/cm$^2$.hr, formed on the semiconductor element of the chip, and (b) a radiation shielding metal layer formed on the insulating material layer, and thermally resisting, insulating material layer and the radiation shielding metal layer extending over a region so as to cover the semiconductor element.

An embodiment of a semiconductor device according to the invention will now be illustrated with reference to the accompanying drawing, in which:

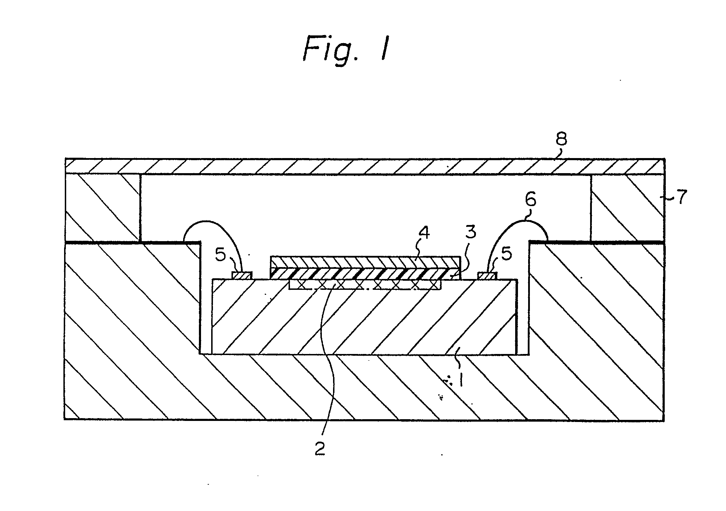

Fig. 1 is a cross-sectional view of one example of the semiconductor device of the invention.

A silicon substrate chip 1 has a semiconductor element 2 formed on one side of the chip. The semiconductor element 2 consists of an integrated circuit such as a MOS device or a charge transfer device. The chip 1 has a layer 3 of a thermally resisting, insulating material containing no radioactive element, formed on the semiconductor element 2 of the chip 1. As the thermally resisting, insulating material, polyimide resins are preferably used. By the term "containing substantially no radioactive element" used in this specification, is meant that no alpha rays can be detected in the insulating material or alpha rays are detected only at a particle flux of not larger than 0.1 p/cm$^2$.hr., preferably not larger than 0.01 p/cm$^2$.hr. The thickness of the thermally resisting, insulating material layer 3 is in the range of from 5 to 100 μm, preferably in the range of from 5 to 15 μm.

Furthermore, the chip 1 has a radiation shielding metal layer 4 formed on the insulating material layer 3. The radiation shielding metal layer 4 may be made of a chemically stable metal such as gold. The radiation shielding metal layer 4 may be either a single layer such as, for example, a gold plating layer, or multi layered, such as, for example, a combination of a priming nickel vapor deposition layer with a top gold plating layer, or a combination of a priming titanium vapor deposition layer, a medial nickel vapor deposition layer and a top gold plating layer. The thickness of the radiation shielding metal layer 4 is preferably in the range of from 1 to 50 μm more preferably in the range of from 5 to 10 μm.

The thermally resisting, insulating layer 3 has a function of insulation between the radiation shielding metal layer 4 and wirings connecting MOS devices with each other in the semiconductor element 2 and exposed through a SiO$_2$ film, and further, a function of shielding radiation.

Bonding pads 5 are formed, for example, through a SiO$_2$ film layer on the silicon substrate chip 1, which pads 5 are connected to the wiring of the integrated circuit. The bonding pads 5 are connected to the wiring of the integrated circuit 2 through a bonding wire 6 with external connection leads (not shown) formed in a carrier 7 of the package.

The semiconductor device of the invention may be manufactured as follows. First, a silicon substrate chip 1 having a semiconductor element 2 and bonding pads 5, formed on one side thereof, is prepared. The entire surface of the chip 1 is coated with a polyimide resin layer 3 and, then, the polyimide coating 3 is cured. Thereafter, a gold film layer 4 of several μm in thickness is formed on the polyimide coating 3 by means of, for example, vapor deposition or plating. The gold film layer-formed chip is etched, whereby a portion of the gold film layer is removed, which portion is other than the region covering the semiconductor element 2. Thereafter, the polyimide coating 3 is partially removed by treating the polyimide coating with a solvent utilizing the remaining gold film layer 4 as a mask. The so prepared silicon substrate chip 1 having the polyimide coating 3 on the semiconductor element 2 and, further, having the gold film layer 4 on the polyimide coating 3 is placed on a preform formed of, e.g., gold, which preform has been previously placed in the recess of the carrier 7 made of an insulating material. The carrier 7 is heated to a suitable temperature, whereby a silicon-gold eutectic is caused to form, thus, bonding the substrate chip to the carrier. The formation of a connection between the pads 5 and the leads by means of the bonding wires 6, and the sealing of the entire assembly in a furnace may be conducted by conventional procedures.

By the radiation shielding structure, i.e., the thermally resisting, insulating material layer having no substantially radioactive element and the radiation shielding metal layer, formed in turn on the silicon substrate, the semiconductor element can be completely protected from irradiation by alpha rays and other radiation emitted from the packaging parts such as the carrier and the cover or lid. Thus, the semiconductor device of the invention neither suffers from soft errors not deteriorates in its characteristics.

Table of reference numerals and parts

1—Silicon substrate chip
2—Semiconductor element
3—Thermally resisting, insulating material layer
4—Radiation shielding metal layer
5—Bonding pads
6—Bonding wire
7—Carrier
8—Cover

## Claims

1. A semiconductor device comprising a chip (1) with a semiconductor element (2) formed on one side thereof, said chip being fixed in a recess formed in a carrier (7) made of an insulating material and being sealed with a cover (8) with a predetermined space therebetween; said device further comprising (a) a layer (3) of a thermally resisting, insulating material exhibiting a particle flux of not larger than 0.1 particle/cm².hr, formed on the semiconductor element of the chip, and (b) a radiation shielding metal layer (4) formed on the insulating material layer, the thermally resisting, insulating material layer and the radiation shielding metal layer extending over a region so as to cover the semiconductor element.

2. The semiconductor device according to claim 1, wherein said thermally resisting, insulating material (3) is a polyimide resin.

3. The semiconductor device according to claim 1 or 2, wherein the radiation shielding metal layer (4) is made of gold.

4. The semiconductor device according to claim 1 or 2, wherein said layer of the thermally resisting, insulating material (3) has a thickness of from 5 to 100 µm.

5. The semiconductor device according to claim 3, wherein the radiation shielding metal layer (4) has a thickness of from 1 to 50 µm.

## Patentansprüche

1. Halbleitervorrichtung mit einem Chip (1) mit einem Halbleiterelement (2), welches auf einer Seite desselben angeordnet ist, wobei das Chip in einer Ausnehmung befestigt ist, die in einem Träger (7) geformt ist, der aus isolierendem Material besteht, und mit einer Abdeckung (8) versiegelt ist, mit einem vorbestimmten Abstand dazwischen; welche Vorrichtung ferner umfaßt:
(a) eine Schicht (3) aus thermisch widerstandsfähigem, isolierendem Material, welches einen Teilchenfluß von nicht mehr als 0,1 Teilchen/cm². std aufweist und welches auf dem Halbleiterelement auf dem Chip gebildet ist, und
(b) eine Strahlung abschirmende Metallschicht (4), welche auf der isolierenden Materialschicht gebildet ist, wobei die thermisch widerstandsfähige, isolierende Materialschicht und die die Strahlung abschirmende Metallschicht sich so über einen Bereich erstrecken, daß sie das Halbleiterelement bedecken.

2. Halbleitervorrichtung nach Anspruch 1, bei welcher das genannte thermisch widerstandsfähige, isolierende Material ein Polyimidharz ist.

3. Halbleitervorrichtung nach Anspruch 1 oder 2, bei welcher die Strahlung abschirmende Metallschicht (4) aus Gold besteht.

4. Halbleitervorrichtung nach Anspruch 1 oder 2, bei welcher die genannte Schicht aus thermisch widerstandsfähigem, isolierendem Material (3) eine Dicke von 5 bis 100 µm hat.

5. Halbleitervorrichtung nach Anspruch 3, bei welcher die Strahlung abschirmende Metallschicht (4) eine Dicke von 1 bis 50 µm hat.

## Revendications

1. Dispositif semiconducteur comprenant une puce (1) sur un cöté de laquelle est formé un élément semiconducteur (2), ladite puce étant fixée dans un évidement formé dans un support (7) fait d'un matériau et étant enfermée hermétiquement à l'aide d'un couvercle (8) de façon qu'un espace prédéterminé soit laissé entre eux; ledit dispositif comprenant en outre (a) une couche (3) d'un matériau isolant thermiquement résistant qui présente un flux de particules ne dépassant pas 0,1 particule/cm².h, la couche étant formé sur l'élément semiconducteur de la puce, et (b) une couche métallique (4) de blindage vis-à-vis des rayonnements formée sur la couche de matériau isolant, la couche de matériau isolant thermiquement résistant et la couche métallique de blindage vis-à-vis des rayonnements s'étendant au-dessus d'une région de façon à couvrir l'élément semiconducteur.

2. Dispositif semiconducteur selon la revendication 1, où ledit matériau isolant thermiquement résistant (3) est une résine de polyimide.

3. Dispositif semiconducteur selon la revendication 1 ou 2, où la couche métallique (4) de protection vis-à-vis des rayonnements est faite d'or.

4. Dispositif semiconducteur selon la revendication 1 ou 2, où ladite couche de matériau isolant thermiquement résistant (3) possède une épaisseur de 5 à 100 µm.

5. Dispositif semiconducteur selon la revendication 3, où la couche métallique (4) de protection vis-à-vis des rayonnements a une épaisseur de 1 à 50 µm.

# Fig. 1